# EUROPEAN PATENT APPLICATION

(11) **EP 2 453 474 A1**
(43) Date of publication of application: **16.05.2012**
(21) Application number: 10190714.5
(22) Date of filing: 10.11.2010
(51) Int. Cl.: H01L 21/78

(54) **Semiconductor device packaging method and semiconductor device package**

(71) Applicant: NXP B.V., 5656 AG Eindhoven (NL)
(72) Inventor: Walczyk, Sven, Redhill, Surrey RH1 1DL (GB); Groenhuis, Roelf Anco Jacob, Redhill, Surrey RH1 1DL (GB); Dijkstra, Paul, Redhill, Surrey RH1 1DL (GB); De Bruin, Emiel, Redhill, Surrey RH1 1DL (GB); Brenner, Rolf, Redhill, Surrey RH1 1 DL (GB)
(74) Representative: Burton, Nick

(57) **Abstract**

Disclosed is a method of manufacturing a discrete semiconductor device package (100), comprising providing a wafer comprising a plurality of semiconductor devices (50), each of said semiconductor devices comprising a substrate (110) having a top contact (130) and a bottom contact (150); partially sawing said wafer with a first sawing blade such that the semiconductor devices are partially separated from each other by respective incisions (20); lining said incisions with an electrically insulating film (160); and sawing through said incisions with a second sawing blade such that the semiconductor devices are fully separated from each other. A resulting discrete semiconductor device package (100) and a carrier (200) comprising such a discrete semiconductor device package (100) are also disclosed.

## Description

### FIELD OF THE INVENTION

The present invention relates to a method of manufacturing a discrete semiconductor device package, comprising providing a wafer comprising a plurality of semiconductor devices, each of said semiconductor devices comprising a substrate having a top contact and a bottom contact.

The present invention further relates to a discrete semiconductor device package, comprising a semiconductor device that comprises a substrate having a top contact and a bottom contact.

The present invention yet further relates to a carrier comprising such a discrete semiconductor device package.

### BACKGROUND OF THE INVENTION

Discrete semiconductor devices such as diodes are typically provided in a package when marketed. The package protects the discrete semiconductor device from accidental damage and provides the contacts for integrating the discrete semiconductor device in a larger electronic device, e.g. by mounting the discrete semiconductor device on a printer circuit board (PCB). In the known packaging approaches, the package contacts are typically fan-outs of the contacts of the discrete semiconductor device, i.e. have a larger area, as manufacturing approaches to reproduce the small dimensions of a discrete semiconductor device at the package level in a straightforward and cost-effective manner are currently unavailable.

As a consequence of the ongoing miniaturization of semiconductor devices including discrete semiconductor devices, the corresponding package sizes have to be miniaturized as well. This, however, is not trivial, as the fan-out of the package contacts poses a lower limit of the dimensions of the package. For instance, for diode packages, it is difficult to miniaturize the package beyond dimensions of 0.6 mm x 0.3 mm x 0.3 mm. Such packages are known as 0603 packages. This lower limit is largely dictated by the dimensions of the fan-out package contacts.

A further problem exists when such a package is to be mounted sideways on a carrier, such that its top and bottom contacts are connected to the carrier by a vertically extending connection, which typically is a solder portion. As the solder portion extends to the interface between the package and the carrier, i.e. also covers part of the package sidewall facing the carrier, a parasitic conductive connection is formed between the carrier and the semiconductor substrate of the package, if electrically uninsulated. This is particularly relevant if the substrate comprises a laterally extending p-n junction, such as in the case of a discrete diode package, as such a parasitic conductive connection can result in an undesirable leakage current between the top and bottom contacts of the package. Placement of the package in a resin molding layer may obviate such leakage currents but has the disadvantage that it significantly increases the dimensions of the discrete semiconductor device package.

Hence, there exists a need for a packaging method that facilitates further miniaturization of discrete semiconductor device packages and in particular diode packages in a relatively straightforward and therefore cost-effective manner.

### SUMMARY OF THE INVENTION

The present invention seeks to provide a method of manufacturing a discrete semiconductor device package that facilitates the manufacture of packages smaller than 0603 packages.

The present invention further seeks to provide a discrete semiconductor device package obtained by such a method.

The present invention yet further seeks to provide a carrier comprising such a discrete semiconductor device package.

According to an aspect of the present invention, there is provided a method of manufacturing a discrete semiconductor device package, comprising providing a wafer comprising a plurality of semiconductor devices, each of said semiconductor devices comprising a substrate having a top contact and a bottom contact; cutting said wafer such that the semiconductor devices are partially separated from each other by respective incisions; lining said incisions with an electrically insulating film; and individualizing the semiconductor devices using said incisions as a starting point such that the semiconductor devices are fully separated from each other.

By applying a two-step individualization process a single lining step can be applied to all semiconductor devices on the wafer, which has the advantage of increased ease of handling and reduced cost. In addition, the lining step allows for a very thin film of the electrically insulating material to be applied, thereby limiting the overall size of the discrete semiconductor package. The completion of the individualization step may be performed e.g. by sawing, laser cutting, and so on. Preferably, in case of an initial sawing step to form the incisions a sawing blade is used that is already in use in the manufacturing process, as this allows for the existing wafer pitch to be used.

The lining step is preferably performed by spray coating, as spray coating can be used to yield very thin films of homogeneous thickness. Alternatively, spin coating or other suitable coating techniques may be used.

In an embodiment, the cutting step is performed using a first sawing blade and the individualization step is performed using a second sawing blade that has a smaller blade width than the first sawing blade to ensure that tolerances and process variations are taken into consideration.

Preferably, the top contact is finished with solderable surface to ensure a good quality conductive contact with a solder portion when mounting the package on a carrier such as a printed circuit board (PCB). The bottom contact may be a back side metallization contact for similar reasons.

In an embodiment, the discrete semiconductor device comprises a p-n junction extending laterally through said substrate, said incision extending beyond the p-n junction. This ensures that the part of the p-n junction that is exposed at the sidewalls of the discrete semiconductor device package is electrically insulated from any solder located in between a conductive carrier surface and the side wall of the package facing this surface.

According to another aspect of the present invention, there is provided a discrete semiconductor device package including a semiconductor device comprising a substrate having a top contact and a bottom contact, wherein the side walls of the semiconductor device are partially covered by an electrically insulating film. As previously explained, such a package can be made in a simple and cost-effective manner, and can be made smaller than the existing 0603 packages. This has the further advantage that such a package may be used with carriers designed for use with 0603 packages in which the bottom contact of the 0603 package is to face the carrier surface as the height of the package of the present invention can be designed to match the width of a 0603 package, such that by sideways mounting of the package of the present invention no redesign of the carrier is required.

The top contact preferably is finished with solderable surface and/or the bottom contact preferably is a back side metallization contact for reasons already explained above.

In an embodiment, the side walls of the package comprise a step profile, said step profile comprising a first vertical section, a second vertical section and a horizontal section, said first vertical section connecting the top surface of the discrete semiconductor device with the horizontal section, said second vertical section connecting the bottom surface of the discrete semiconductor device with said horizontal section, wherein the first vertical section and the horizontal section are covered by the electrically insulating film. The step profile is the result of the two-step sawing process using different width sawing blades.

Preferably, the discrete semiconductor device comprises a p-n junction laterally extending through said substrate, wherein the electrically insulating film extends beyond said p-n junction. This effectively protects the side wall of the package that is to face the surface of a carrier from short circuits leading to the previously mentioned undesirable leakage currents. An example of a discrete semiconductor device having such a p-n junction is a diode although other discrete semiconductor devices, e.g. transistors, are also feasible.

In accordance with yet another aspect of the present invention, there is provided a carrier comprising a surface comprising a first contact and a second contact; and a discrete semiconductor device package according to an embodiment of the present invention, wherein the discrete semiconductor device package is mounted sideways on said carrier surface such that one of said side walls faces the carrier surface, wherein said first contact is conductively coupled to the top contact via a first solder portion, and wherein said second contact is conductively coupled to the bottom contact via a second solder portion, said first solder portion being electrically insulated from the one of said side walls by the electrically insulating film. Such carrier benefits from reduced leakage currents between its first and second contacts, thereby improving the performance characteristics of the carrier when in operation.

### BRIEF DESCRIPTION OF THE EMBODIMENTS

Embodiments of the invention are described in more detail and by way of non-limiting examples with reference to the accompanying drawings, wherein:
FIG. 1 schematically depicts a discrete semiconductor device package mounted sideways on a carrier;
FIG. 2-5 schematically depict various stages of an embodiment of the method of the present invention; and
FIG. 6 schematically depicts a discrete semiconductor device package according to an embodiment of the present invention mounted sideways on a carrier.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

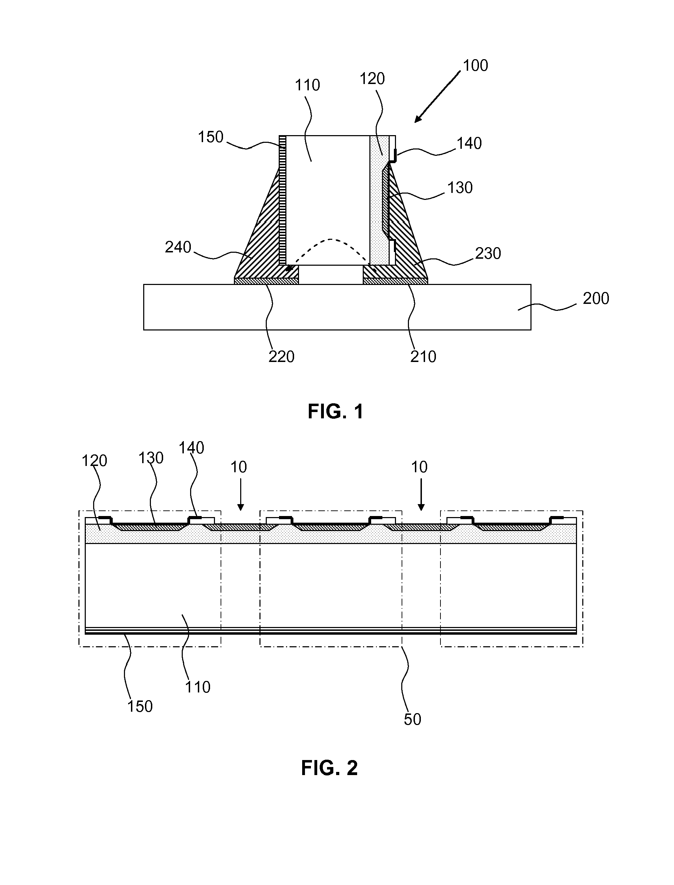

FIG. 1 schematically depicts a discrete semiconductor device package 100 mounted sideways on a carrier 200 such as a PCB. The discrete semiconductor device package 100 comprises a top contact 130 and a bottom contact 150, with a wetting layer 140 applied to the top contact 130 to increase its solderability, i.e. its adhesion to a solder material. Such a wetting layer may be a plating layer or an under-bump metallization (UBM). Suitable materials for the wetting layer 140 are well-known to the skilled person. A further wetting layer (not shown) may be applied to the bottom contact 150. Alternatively, the bottom contact 150 may be made of a material having good adhesive properties with the solder to be applied thereto.

The discrete semiconductor device may comprise a substrate 110 of a first conductivity type, in which a region 120 of a second and opposite conductivity type is formed, such that the discrete semiconductor device comprises a p-n junction that laterally extends through the substrate 110. For instance, the semiconductor substrate 110 may be an n-type substrate with the region 120 being a p-type material or vice versa. The laterally extending p-n junction may extend from sidewall to sidewall of the discrete semiconductor device package 100.

A problem associated with such packages is that when they are mounted sideways on a carrier 200 such as shown in FIG. 1, the solder portion 230, which establishes the conductive connection between the first contact 210 of the carrier 200 and the top contact 130 of the discrete semiconductor device package 100, may extend to in between the sidewall of the discrete semiconductor device package 100 facing the surface of the carrier 200 and the carrier 200 itself. This conductively connects the solder portion 230 with the p-n junction, such that a leakage current between the first solder portion 230 and the second solder portion 240 conductively connecting the second contact 220 of the carrier 200 to the bottom contact 150 of the discrete semiconductor device package 100 can occur. This leakage current path is indicated by the dashed arrow in FIG. 1.

It will be appreciated that such leakage current paths should be avoided as they deteriorate the performance of the discrete semiconductor device in the discrete semiconductor device package 100 or worse can cause faulty behavior of the discrete semiconductor device. The presence of such a leakage current path may be prevented by electrically insulating the side walls of the discrete semiconductor device package 100. However, this can be an involved, i.e. costly, process, for which it is not at al trivial how to reduce the dimensions of the resulting package below the dimensions of e.g. a 0603 package.

The present application discloses a method of providing a small form factor discrete semiconductor device package 100 that can be realized at dimensions well below the dimensions of existing packages, in particular a 0603 package.

FIG. 2 depicts a first stage of an embodiment of the method of the present invention. A finished wafer is provided comprising a plurality of semiconductor devices 50 separated from each other by saw or scribe lanes 10. As a first stage of the packaging process, the wafer may have been processed to provide the bottom contacts 150 to the semiconductor devices 50, as well as the wetting layer 140 over the top contacts 130 of the semiconductor devices 50. Such processing steps are known per se and will not be explained in further detail for the sake of brevity. Any suitable metallization may be used for the bottom contact 150, e.g. metallization stacks such as TiNiAg, Au(As)AgNiAg and so on may be used. Similarly, any suitable material may be used for the wetting layer 140, such as tin, silver, metal alloys and layer stacks such as a niAu finish, NiPdAu and so on. The plating layer 140 may be applied in any suitable manner, e.g. electroless plating may be used.

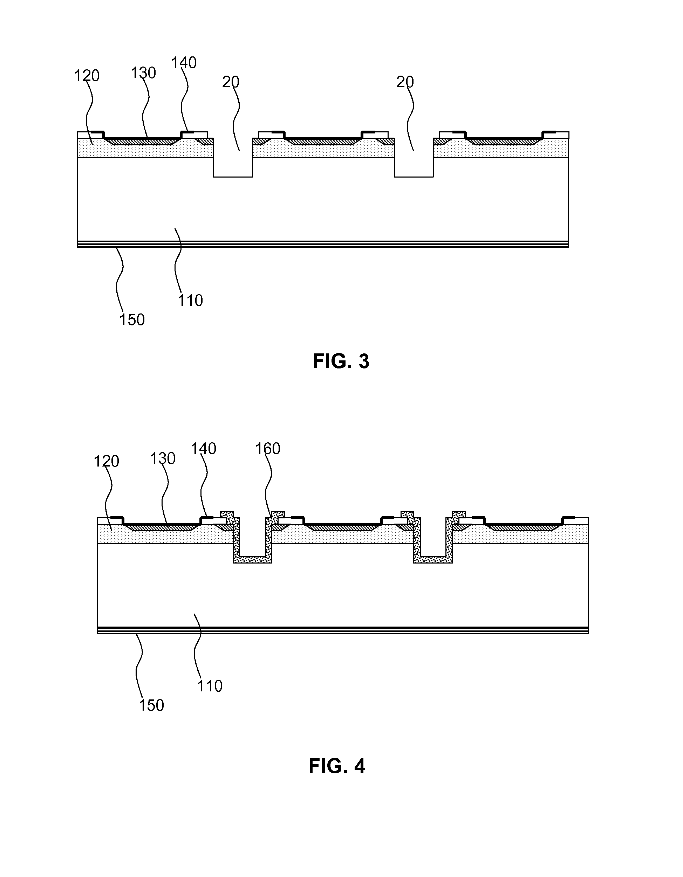

The method proceeds as shown in FIG. 3, in which a partial cutting step is applied to the wafer to form incisions or cuts 20 in the sawing lanes 10 of the wafer. Preferably, the depth of these incisions 20 extends beyond the p-n junction formed by the substrate 110 and the doped region 120. This partial cutting step may be performed in any suitable manner, such as with any suitable sawing blade, laser cutting and so on. In case of sawing, the width of the sawing blade used for making the incisions 20 is chosen such that the width of the incisions 20 is smaller than the width of the sawing lanes 10. This provides tolerances in the partial sawing step; the sawing blade does not need extremely accurate aligning such that the sawing step can be performed relatively easily. Since (partial) wafer sawing is well-known per se, no further details will be given for the sake of brevity only.

In a next step, shown in FIG. 4, the incisions 20 are lined with an electrically insulating layer 160. Preferably, the insulating layer 160 is deposited by spray coating as this provides a very thin yet homogenous layer. In an embodiment, a masking layer is first added to the wafer covering the areas that should be kept uncovered by the electrically insulating layer 160. In a next step, electrically insulating layer 160 is applied in any suitable manner such as by spray coating or spin coating, and subsequently cured. After curing, the masking material is removed from the wafer.

The insulating layer 160 may be cured in any suitable manner, e.g. by exposure to heat (thermal curing) or by exposure to electromagnetic radiation of a suitable wavelength, e.g. UV or visible light (photo-induced curing). Any curable electrically insulating polymer material may be used as material for the electrically insulating layer 160. Examples of suitable materials for the insulating layer include butyl-chloro-benzimidazole, polyimide and so on. As can be seen in FIG. 4, the cured electrically insulating layer 160 covers the side walls of the discrete semiconductor device 50 including the p-n junction formed by the substrate 110 of a first conductivity type and the layer 120 doped with an impurity of an opposite conductivity type.

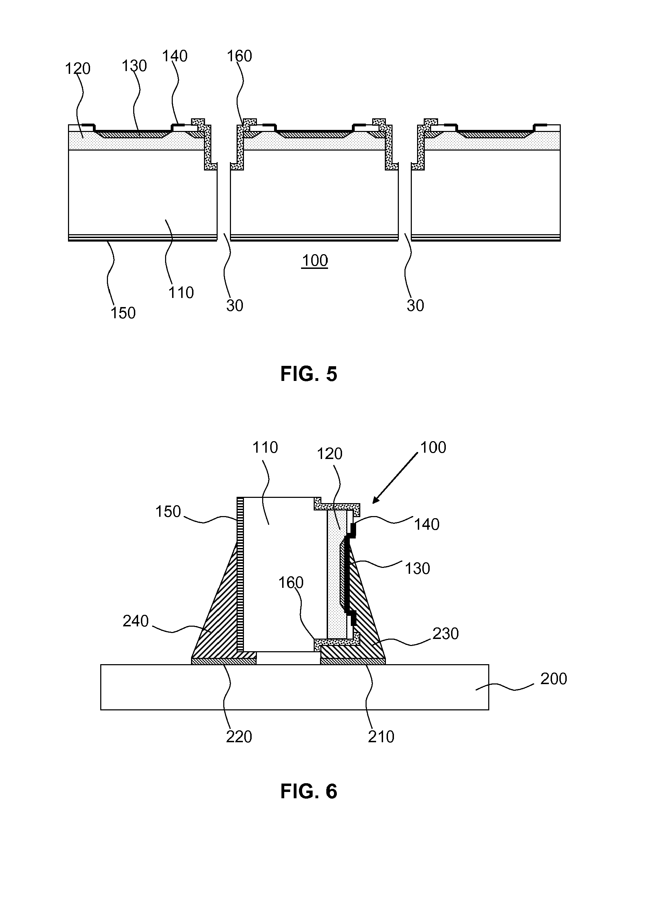

After the deposition of the electrically insulating layer 160, the individualization of the discrete semiconductor device packages 100 is completed by a second sawing step as shown in FIG. 5, in which incisions 30 extending through the remainder of the wafer are formed. Preferably, the sawing blade used for this second sawing step has a smaller width than the sawing blade used for the first sawing step, i.e. used for forming incisions 20 to provide tolerances in the sawing process and to account for process variations in the manufacturing of the discrete semiconductor devices 50.

When using a smaller width blade for the second sawing step, a discrete semiconductor device package 100 is obtained that has a step profile, as shown in FIG. 5. The step profile comprises a first vertical section connecting the top surface of the discrete semiconductor device 50 with a horizontal section of the step profile and a second vertical section connecting the bottom surface of the discrete semiconductor device with the horizontal section, wherein the first vertical section and the horizontal section are covered by the electrically insulating film, as can be recognized in FIG. 5.

At this point it is noted that although the example embodiment of the method of the present invention has been described in the context of a discrete semiconductor device 50 having a lateral p-n junction, such as a discrete diode, a transistor and so on, the method of the present invention is equally applicable to any semiconductor device package in which the occurrence of a leakage current path through a sidewall of the device has to be avoided. This may for instance contain a discrete semiconductor device without a lateral p-n junction.

FIG. 6 schematically depicts an example embodiment of a discrete semiconductor device package 100 mounted sideways on a carrier 200. As can be seen, the electrically insulating film 160 prevents conductive contact between the solder portion 230 and the sidewall of the discrete semiconductor device package 100, such that the leakage current path shown in FIG. 1 by way of the dashed arrow does not occur.

At this stage, it is pointed out that the depth of the first incision 20, which defines the height of the sidewall portion of the discrete semiconductor device package 100 to be covered by the electrically insulating film 160 is typically chosen such that the electrically insulating film 160 extends beyond the solder portion 230 when placed facing the surface of the carrier 200. The p-n junction defined by the substrate 110 and the impurity containing layer 120 is preferably covered by the electrically insulating film 160 for reasons previously explained.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of manufacturing a discrete semiconductor device package (100), comprising:
providing a wafer comprising a plurality of semiconductor devices (50), each of said semiconductor devices comprising a substrate (110) having a top contact (130) and a bottom contact (150);
partially cutting said wafer such that the semiconductor devices are partially separated from each other by respective incisions (20);
lining said incisions with an electrically insulating film (160); and
individualizing the semiconductor devices using said incisions as a starting point such that the semiconductor devices are fully separated from each other.

2. The method of claim 1, wherein said lining step is performed by spray coating.

3. The method of claim 1, wherein said lining step is performed by spin coating.

4. The method of any of claims 1-3, wherein the cutting step is performed using a first sawing blade and the individualization step is performed using a second sawing blade that has a smaller blade width than the first sawing blade.

5. The method of any of claims 1-4, wherein the top contact (130) is finished with a solderable surface (140).

6. The method of any of claims 1-5, wherein the bottom contact (150) is a back side metallization contact. Back side metal can be any solderable finish such as TiNiAg or alternatively NiPdAu or similar

7. The method of any of claims 1-6, wherein the discrete semiconductor device (50) comprises a p-n junction extending laterally through said substrate (110), said incision (20) extending beyond the p-n junction.

8. A discrete semiconductor device package (100) including a semiconductor device (50) comprising a substrate (110) having a top contact (130) and a bottom contact (150), wherein the side walls of the semiconductor device are partially covered by an electrically insulating film (160).

9. The discrete semiconductor device package (100) of claim 8, wherein the top contact (130) is finished with a solderable surface (140).

10. The discrete semiconductor device package (100) of claim 8 or 9, wherein the bottom contact (150) is a back side metallization contact.

11. The discrete semiconductor device package (100) of any of claims 8-10, wherein the discrete semiconductor device (50) is a diode or a transistor.

12. The discrete semiconductor device package (100) of any of claims 8-11, wherein said side walls comprise a step profile, said step profile comprising a first vertical section, a second vertical section and a horizontal section, said first vertical section connecting the top surface of the discrete semiconductor device (50) with the horizontal section, said second vertical section connecting the bottom surface of the discrete semiconductor device (50) with said horizontal section, wherein the first vertical section and the horizontal section are covered by the electrically insulating film (160).

13. The discrete semiconductor device package (100) of any of claims 8-12, wherein the discrete semiconductor device (50) comprises a p-n junction laterally extending through said substrate (100), wherein the electrically insulating film (160) extends beyond said p-n junction.

14. A carrier (200) comprising:
a surface comprising a first contact (210) and a second contact (220); and
the discrete semiconductor device package (100) of any of claims 8-13, wherein the discrete semiconductor device package is mounted sideways on said carrier surface such that one of said side walls faces the carrier surface, wherein said first contact is conductively coupled to the top contact (130) via a first solder portion (230), and wherein said second contact is conductively coupled to the bottom contact (150) via a second solder portion (240), said first solder portion being electrically insulated from the one of said side walls by the electrically insulating film (160).

15. The carrier (200) of claim 14, wherein the carrier comprises a printed circuit board.

## Amended claims

### Amended claims in accordance with Rule 137(2) EPC.

**1.** A method of manufacturing a discrete semiconductor device package (100), comprising:
providing a wafer comprising a plurality of semiconductor devices (50), each of said semiconductor devices comprising a substrate (110) having a top contact (130) and a bottom contact (150);
partially cutting said wafer such that the semiconductor devices are partially separated from each other by respective incisions (20);
lining said incisions with an electrically insulating film (160); and
individualizing the semiconductor devices using said incisions as a starting point such that the semiconductor devices are fully separated from each other; wherein side walls of the semiconductor devices comprise a step profile, said step profile comprising a first vertical section, a second vertical section and a horizontal section, said first vertical section connecting the top surface of the discrete semiconductor device (50) with the horizontal section, said second vertical section connecting the bottom surface of the discrete semiconductor device (50) with said horizontal section, wherein the first vertical section and the horizontal section are covered by the electrically insulating film (160) such that the outer surface of the insulating film follows the step profile.

**2.** The method of claim 1, wherein said lining step is performed by spray coating.

**3.** The method of claim 1, wherein said lining step is performed by spin coating.

**4.** The method of any of claims 1-3, wherein the cutting step is performed using a first sawing blade and the individualization step is performed using a second sawing blade that has a smaller blade width than the first sawing blade.

**5.** The method of any of claims 1-4, wherein the top contact (130) is finished with a solderable surface (140).

**6.** The method of any of claims 1-5, wherein the bottom contact (150) is a back side metallization contact. Back side metal can be any solderable finish such as TiNiAg or alternatively NiPdAu or similar

**7.** The method of any of claims 1-6, wherein the discrete semiconductor device (50) comprises a p-n junction extending laterally through said substrate (110), said incision (20) extending beyond the p-n junction.

**8.** A discrete semiconductor device package (100) including a semiconductor device (50) comprising a substrate (110) having a top contact (130) and a bottom contact (150), wherein the side walls of the semiconductor device are partially covered by an electrically insulating film (160) comprise a step profile, said step profile comprising a first vertical section, a second vertical section and a horizontal section, said first vertical section connecting the top surface of the discrete semiconductor device (50) with the horizontal section, said second vertical section connecting the bottom surface of the discrete semiconductor device (50) with said horizontal section, wherein the first vertical section and the horizontal section are covered by the electrically insulating film (160) such that the outer surface of the insulating film follows the step profile.

**9.** The discrete semiconductor device package (100) of claim 8, wherein the top contact (130) is finished with a solderable surface (140).

**10.** The discrete semiconductor device package (100) of claims 8 or 9, wherein the bottom contact (150) is a back side metallization contact.

**11.** The discrete semiconductor device package (100) of any of claims 8-10, wherein the discrete semiconductor device (50) is a diode or a transistor.

**12.** The discrete semiconductor device package (100) of any of claims 8-11, wherein the discrete semiconductor device (50) comprises a p-n junction laterally extending through said substrate (100), wherein the electrically insulating film (160) extends beyond said p-n junction.

**13.** A carrier (200) comprising:
a surface comprising a first contact (210) and a second contact (220); and
the discrete semiconductor device package (100) of any of claims 8-12, wherein the discrete semiconductor device package is mounted sideways on said carrier surface such that one of said side walls faces the carrier surface, wherein said first contact is conductively coupled to the top contact (130) via a first solder portion (230), and wherein said second contact is conductively coupled to the bottom contact (150) via a second solder portion (240), said first solder portion being electrically insulated from the one of said side walls by the electrically insulating film (160).

**14.** The carrier (200) of claim 13, wherein the carrier comprises a printed circuit board.
